# EUROPEAN PATENT APPLICATION

(11) **EP 3 919 921 A1**
(43) Date of publication of application: **08.12.2021**
(21) Application number: 21173357.1
(22) Date of filing: 11.05.2021
(51) Int. Cl.: G01R 1/04, H04B 3/46, H04L 12/24

(54) **A DETACHABLE TEST INSTRUMENT REMOTE CONTROLLER**

(30) Priority: 11.05.2020 GB 202006932
(71) Applicant: Trend Networks Limited, High Wycombe, Buckinghamshire HP14 3SX (GB)
(72) Inventor: Mercer, Ian, High Wycombe, HP14 3SX (GB); Kent, Peter, High Wycombe, HP14 3SX (GB)
(74) Representative: Spencer, Michael David

(57) **Abstract**

The present invention relates to a detachable test instrument remote controller 10 comprising a top part 2 comprising a housing including a switch or a plug 30 having switch means for connecting to a testing cable 42, a bottom part 1 configured to be fitted on a patch cable 20 and adapted to secure the top part 2 to the patch cable 20, and a testing cable 42 connected to the top part 2 and adapted to be communicatively coupled with a tester product 46, wherein once the bottom part 1 is fitted to the patch cable 20, the top part 2 is slid onto it and held in place such that the housing, when in use, covers at least part of the plug 30 not in the socket/or abuts the plug 30. The present invention also relates to a cable 42 for a circuit tester comprising the detachable test instrument remote controller 10.

## Description

The present invention relates to a detachable test instrument remote controller for patch cables in the field of tester products. It further relates to a detachable test instrument remote controller and indicator.

LAN cabling is commonly used to connect equipment such as personal computers, printers, and other machines that pass information using high-speed digital signals.

Most of LAN cabling runs within the walls of a building are used to communicatively couple a first piece of equipment to a second piece of equipment. Existing cables for connecting a tester product to a LAN cable (circuit) to be tested incorporate a wire connector to be plugged into the port of the LAN cable for testing the strength and connectivity of a particular type of circuit. Further existing such cables incorporate a wire connector that has a switch and some LEDs which is plugged into the LAN cable to be tested. An initial result of the test will then be notified by the LEDs switching on in a particular colour or pattern.

Wall sockets, such as female RJ45 connector sockets, associated with the LAN cabling are used to receive corresponding RJ45 plugs provided at one end of cables while the other end of the cables are provided with a plug (as needed) for connecting the cable to the piece of equipment. The first and second parts of a circuit/LAN tester are linked for communication via use of the cables and plugs so that they are connected to the LAN cabling for testing. The cable linked to the first part of the LAN tester incorporating the analyser has the cable discussed above with the LED indicator to show quickly if there is a connection.

However, these particular cables with LEDs for the first part of the LAN tester are permanently attached to the LAN tester and cannot be used with alternative patch cables.

It is an aim of the present invention to provide a detachable test instrument remote controller for quick socket testing which can be easily removable and can be used on various type of patch cables.

Accordingly, a first aspect of the present invention is directed to a detachable test instrument remote controller comprising:
- a top part comprising a housing including a switch or a plug having switch means for connecting to a testing cable,
- a bottom part configured to be fitted on a patch cable and adapted to secure the top part to the patch cable, and
- a testing cable connected to the top part and adapted to be communicatively coupled with a tester product,
wherein once the bottom part is fitted to the patch cable the top part is slid onto it and held in place such that the housing, when in use, covers at least part of the plug not in the socket/or abuts the plug.

This provides the advantage that the user can easily fit the testing cable connector to any patch cables.

In a further embodiment, the detachable test instrument remote controller further comprises an indicator means.

Preferably, the indicator means further comprises at least one LED.

The indicating means can provide any desired form of user feedback, such as visual, audio, and/or tactile. Accordingly, and by way of example only, the indicator means can be in the form of one or more LEDs, a speaker, a vibrator, or the like. This will indicate the user whether the test is passed or not. Advantageously, the top part is connected to the bottom part via a low-resistance locking system. Preferably the locking system comprises two tongues with protrusions which engage frictionally with the inside of the top part.

A low resistance locking system will provide the advantages that the removable cable connector will be sufficiently secured to the patch cable but also can be removed quickly by the user.

In a further embodiment, the bottom part is configured in two or more separate pieces that wrap around the cable.

Advantageously, the two or more separate pieces of the bottom part comprises interlocking means.

A second aspect of the present invention is directed to a cable for a circuit tester comprising the detachable test instrument remote controller as described above.

Alternatively other attachment means could be used for the end of cable to be attached next to the socket such as:
- a spring-loaded clip mechanism (e.g. a bulldog clip)
- tie wraps, Velcro strips, adhesive etc.
- being directly over-moulded onto the cable sheath of the patch cable.

An example of a detachable test instrument remote controller according to the present invention will now be described herein below with reference to the accompanying drawings, in which:
Figure 1 is a side perspective view of the bottom part of a detachable test instrument remote controller according to the present invention;
Figure 2 is a side perspective view of a detachable test instrument remote controller removable cable connector shown in Figure 1 with a top part being fitted;
Figure 3 is a side perspective view of a detachable test instrument remote controller in a compact arrangement with the top part fully fitted according to the present invention; and
Figure 4 is a top view of a detachable test instrument remote controller according to the present invention connected to a tester product.

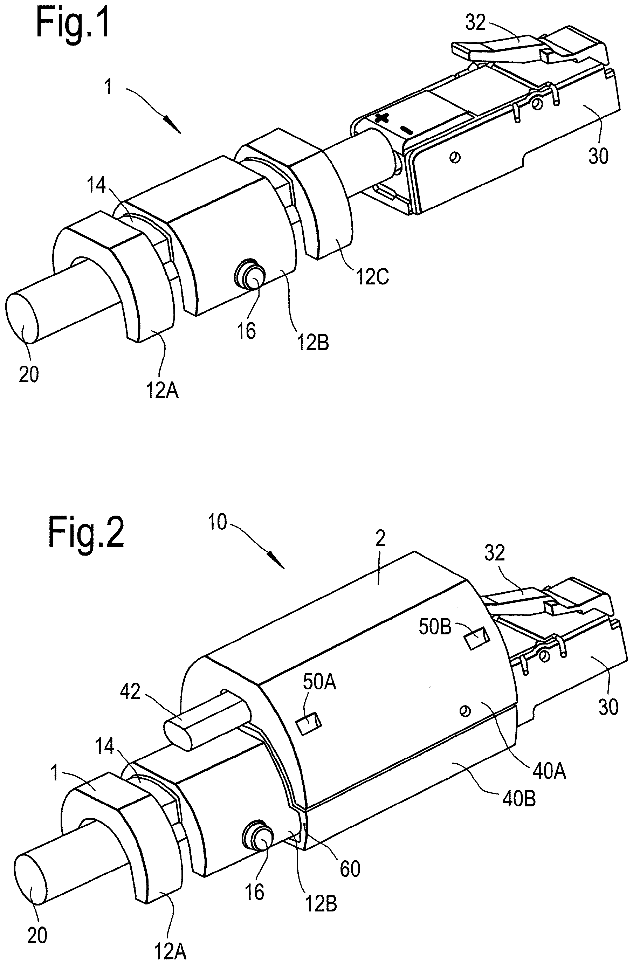

Figure 1 shows the bottom part 1 of a detachable test instrument remote controller 10 (as shown in Figure 2) fitted over a cable sheath 20 of a patch cable connected to a plug 30, in this instance a RJ45 plug. The bottom part 1 is a single piece composed of three semi-circular parts 12A, 12B, 12C which are linked together on a top support 14 above the patch cable 20 when fitted. In this example, the semi-circular part 12B is three times larger than the other two semi-circular parts 12A and 12C located respectively at either end. The semi-circular part 12B also has side protrusions 16 at the centre of its side arranged to be received in the top part 2 of the detachable test instrument remote controller 10. In this case, the side protrusions 16 are circular buttons.

Figure 2 shows the bottom part 1 of the detachable test instrument remote controller 10 partially fitted over the patch cable 20 connected to a plug 30 as described in Figure 1. The top part 2 of the detachable test instrument remote controller 10 comprises two semi-circular parts 40A, 40B interlocking with each other and corresponds to the length of the three semi-circular parts 12A, 12B, 12C of the bottom part 1. The two semi-circular parts 40A, 40B can slid over the RJ45 connector socket to be clipped on the bottom part 1 via its circular button 16. One end of a cable 42 extends into the centre of the outer face of the semi-circular part 40A whose other end is connected via a connector to a first part of the LAN/circuit tester product via a connectivity port. Two holes 50A, 50B are replicated on the respective extremities of each side of the top semi-circular part 40A and are moulding features to reduce tooling costs. The end face of top part of the semi-circular part 40A that receives the cable 42 also contains the switch and the LED or LEDs to indicate the functioning of the circuit. The bottom part 40B has on its two low edges internal channels 60 to receive the side protrusions 16 in a frictional engaging manner and such that further movement is stopped then the top part 2 is in position over the bottom part.

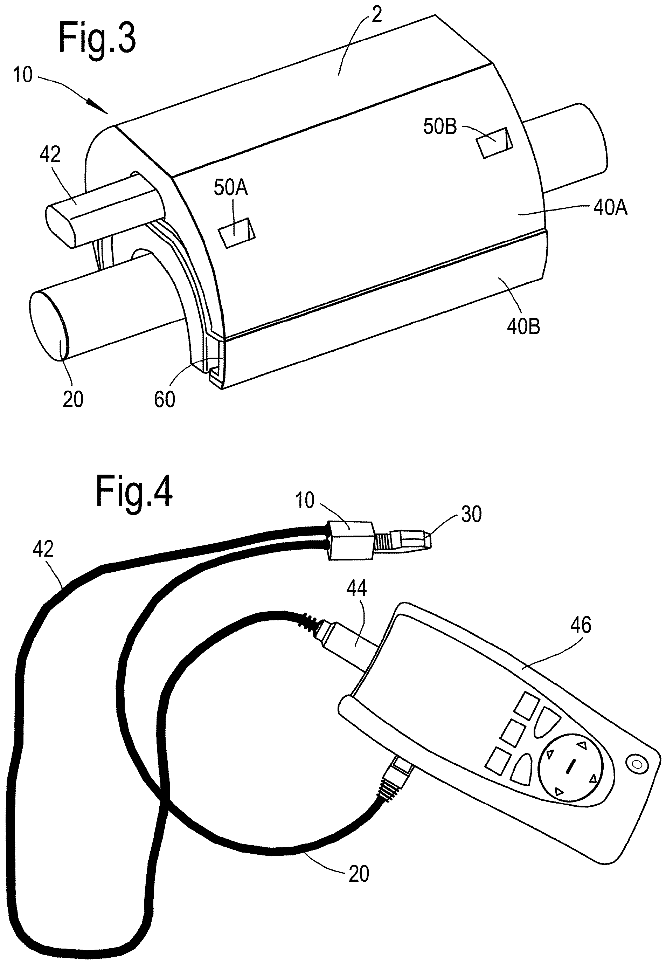

Figure 3 shows a detachable test instrument remote controller 10 fitted over the patch cable 20 as described in Figure 1 where the top part 2 is fully secured over the bottom part 1 of the detachable test instrument remote controller 10 and held in place by the friction locking between the side connectors 16 and the channels 60.

Figure 4 shows a detachable test instrument remote controller 10 fitted over the patch cable 20 that is being used by the first part of the LAN/circuit tester and plugs into a wall socket, e.g. an RJ45 Port. The detachable test instrument remote controller 10 is then connected to the USB port 44 of the tester product 46 via its cable 42.

## Claims

1. A detachable test instrument remote controller comprising:
- a top part comprising a housing including a switch or a plug having switch means for connecting to a testing cable,
- a bottom part configured to be fitted on a patch cable and adapted to secure the top part to the patch cable, and
- a testing cable connected to the top part and adapted to be communicatively coupled with a tester product,
wherein once the bottom part is fitted to the patch cable the top part is slid onto it and held in place such that the housing, when in use, covers at least part of the plug not in the socket/or abuts the plug.

2. A detachable test instrument remote controller according to Claim 1 further comprising an indicator means.

3. A detachable test instrument remote controller according to Claim 2 in which the indicator means comprises at least one LED.

4. A detachable test instrument remote controller according to any preceding claims, in which the top part is connected to the bottom part via a low-resistance locking system.

5. A detachable test instrument remote controller according to Claim 4 in which the low-resistance locking system comprises two tongues with protrusions which engage frictionally with the inside of the top part.

6. A detachable test instrument remote controller according to any preceding claims, in which the bottom part is configured in two or more separate pieces that wrap around the cable.

7. A detachable test instrument remote controller according to Claim 6 in which the two or more separate pieces of the bottom part comprises interlocking means.

8. A cable for a circuit tester comprising the detachable test instrument remote controller.
